Europäisches Patentamt

European Patent Office

Office européen des brevets

(11) Publication number: **0 054 853**
**B1**

(12) **EUROPEAN PATENT SPECIFICATION**

(45) Date of publication of patent specification: **20.05.87**

(21) Application number: **81110323.3**

(22) Date of filing: **11.12.81**

(51) Int. Cl.⁴: **G 11 C 11/40**

(54) **Semiconductor memory device.**

(30) Priority: **24.12.80 JP 183078/80**

(43) Date of publication of application:
**30.06.82 Bulletin 82/26**

(45) Publication of the grant of the patent:
**20.05.87 Bulletin 87/21**

(84) Designated Contracting States:
**DE FR GB**

(56) References cited:
**US-A-4 070 656**
**US-A-4 156 941**
**US-A-4 168 490**

(73) Proprietor: **FUJITSU LIMITED**
**1015, Kamikodanaka Nakahara-ku**
**Kawasaki-shi Kanagawa 211 (JP)**

(72) Inventor: **Sugo, Yasuhisa**
**3-25-13, Minamikoiwa**
**Edogawa-ku Tokyo 133 (JP)**
Inventor: **Toyoda, Kazuhiro**
**39-1433, Sakuradai Midori-ku**
**Yokohama-shi Kanagawa 227 (JP)**
Inventor: **Yamada, Katuyuki**
**2063, Shimosakunobe Takatsu-ku**
**Kawasaki-shi Kanagawa 213 (JP)**

(74) Representative: **Seeger, Wolfgang, Dipl.-Phys.**
**European Patent Attorney Bereiteranger 15**
**D-8000 München 90 (DE)**

Courier Press, Leamington Spa, England.

## Description

The invention relates to a semiconductor memory device, particularly to a semiconductor memory device comprising a plurality of positive word lines, a plurality of negative word lines, a plurality of ECL memory cells, connected between the positive and negative word lines, plural word line level detecting transistors having a base connected to the positive word lines respectively, plural first discharge transistors connected to the negative word lines respectively, and a discharge current provided commonly to the discharge transistors. Such a device is known from US—A—4 156 941.

A memory device, providing so-called the emitter detection type memory cell where a pair of npn type bipolar transistors are cross-coupled and the emitters of such pair of transistors are connected to a pair of bit lines, is often used. A memory device of the type facilitates the coupling between peripheral circuits constituted by the ECL (Emitter Coupled Logic) circuits and memory cells and simultaneously realizes high speed readout operation. These are outstanding advantages of this memory device. Moreover, diversified improvements are attempted in order to realize further high speed readout operation. For example, the reference readout level given to a transistor which connects the sense amplifier and bit line is temporarily lowered when a potential of the word line changes. This method is mainly intended to curtail the rise time of the potential of the word line, but as a method for curtailing the fall time of the potential of the word line, the fall time of the potential of the word line is shortened by giving a discharge current to the selected word lines of memory which are to be operated under larger capacity and lower current.

In regard to the first word line ($W^+$) and the second word line ($W^-$) to which a memory cell is connected, the first word line ($W^+$) is provided with the detecting means which detects a potential of the first word line ($W^+$) and the delay means which delays a detected output, while the second word line ($W^-$) is provided with the discharge means which allows a discharge current to flow from the first word line ($W^+$) via the memory cell, and second word line ($W^-$) in accordance with an output of said delay means.

In such a structure, when the selected word line is to be shifted to the non-selected condition, said discharge means turns ON in accordance with the detected output of said detecting means, allowing the discharge current to flow. As the word line turns into the non-selected condition, the potential of the first word line ($W^+$) is lowered and when it becomes lower than the specified voltage, no detected output can be obtained.

However, said delay means causes a detected output to be applied to the discharge means even when the first word line ($W^+$) is set to a potential which is lower than the specified value and as a result a discharge current flows continuously for some specified period.

Thereby, the first word line voltage is rapidly lowered and the fall time of word line potential is curtailed.

In such existing memory device, on the occasion that the word line is to be shifted to the selected condition from non-selected condition, when a voltage of the first word line ($W^+$) gradually rises and exceeds the specified voltage, said detecting means makes said discharge means ON and the discharge current starts to flow during the word line voltage rises.

Since this discharge current flows into the transistor which is turned ON among the cross-coupled transistors within the memory cell from the first word line ($W^+$), a large amount of charges are stored in the base and collector of transistor which is turned ON.

Therefore, when inverted data is written into this memory cell, in other words, when the transistors which are turned ON among the cross-coupled transistors are turned OFF, a large amount of charges being stored must be absorbed. For this purpose, it is required to give a heavy write current to the memory cell.

Moreover, a heavy discharge current on the first word line ($W^+$) brings about reduction of word line potential due to a voltage drop of the word line. Further, a heavy discharge current flowing via the first word line ($W^+$) causes a heavy base current to flow into the word line driver transistor, resulting in reduction of base potential due to a voltage drop by the resistor existing between the base of word line driver transistor and ground. Thereby, a potential of word line which is lower than the base potential by $V_{BE}$ of the word line driver transistor is further lowered.

When the discharge current flows as explained above, the voltage of the first word line ($W^+$) is lowered and as a result the voltage of the selected word lines comes close to the voltage under the non-selected condition, thus reducing a noise margin.

It is an object of the present invention to provide a semiconductor memory device which assures short fall time of the word line potential without allowing the write current of memory to increase. It is another object of the present invention to provide a semiconductor memory device which assures sufficiently large noise margin.

In order to attain the above-mentioned objects, the present invention as claimed discloses a semiconductor memory device characterised in that said semiconductor memory device comprises a detection circuit which detects changes of the address signal, a second discharge transistor having an emitter commonly connected to the emitters of said first discharge transistors and the discharge current so as to form a current switch together with the first discharge transistors, and a waveform shaping means connected to the detection circuit to form the output signal of the detection circuit, said second discharge transistor turning OFF in accordance with an output of said waveform shaping means,

said first discharge transistors turning ON selectively in accordance with the detected output of said detection circuit and a detected output of said word line level detecting transistor so as to flow temporarily through said negative word line only when said first transistor turns ON due to the change of the address signal.

Various embodiments of methods and apparatus in accordance with this invention will now be described and contrasted with the prior art with reference to the accompanying drawings;

Fig. 1 shows an embodiment of the present invention;

Fig. 2A shows potential change of node B of Fig. 1;

Fig. 2B shows potential change of node C of Fig. 1;

Fig. 2C shows potential change of word line of Fig. 1.

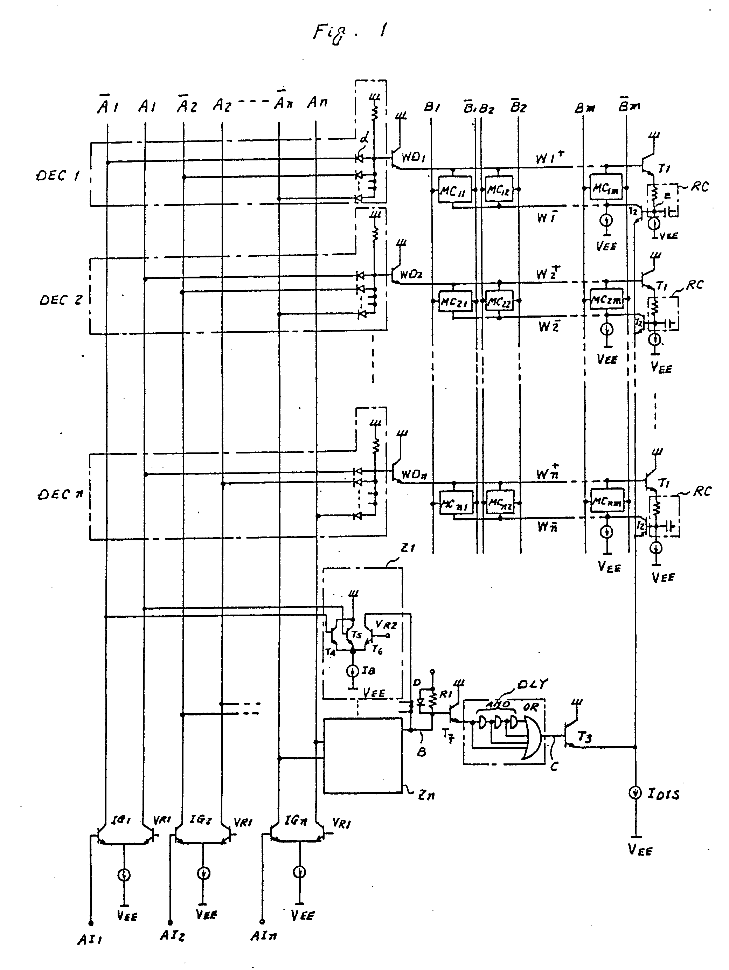

Figure 1 shows an embodiment of the present invention. DEC1... DECn are decoders; WD1...WDn are word line drivers; $W_1^+...W_n^+$ are postive word lines; $W_1^-...W_n^-$ are negative word lines (hold lines); $B_1, \overline{B}_1,...B_m, \overline{B}_m$ are bit lines; $MC_{11}...MCnm$ are memory cells of emitter detection type to be connected to these lines. The decoders $DEC_1...DEC_n$ respectively have plurality of diodes d. The signals $\overline{A}_1, A_1, \overline{A}_2, A_2...$ are generated by the input gates $IG_1, IG_2,...IG_n$ corresponding to each address input $AI_1, AI_2,..., AI_n$ and selectively applied to the diode d. As is well known, the word lines $W_i^+$ are selected through the one word line driver among $WD_1...WD_n$ only when all inputs for plural diodes within each decoder are H (high) level. This condition is established simultanously for only one decoder, at least one input of remaining decoders is L (low) level and the word lines corresponding to these are all kept at the non-selected level.

$T_1$ is the positive word line $W_i^+$ (i=, 2, ..., n) level detection transistor and its emitter output charges the time constant circuit RC becomes the base voltage of discharge transistor $T_2$ which is connected to the negative word line $W_i^-$. These transistors $T_1$, $T_2$ and time constant circuit RC are provided for each word line and the current switch (discharge circuit DIS) for discharge current $I_{DIS}$ is formed with the emitters of all transistors $T_2$ connected in common.

In such discharge circuit DIS having said structure, since the point E of the time constant circuit RC connected to the selected word line $W_i^+$ becomes highest in level, the corresponding transistor $T_2$ turns ON, allowing the discharge current $I_{DIS}$ to flow into the negative word line $W_i^-$. This invention allows such current $I_{DIS}$ to flow only when the selected word line $W_i^+$ shifts to the non-selected level from the selected level. In other words, while said selected word line $W_i^+$ rises to the selected level from the non-selected level and the selected level is maintained continuously under the normal condition, the current $I_{DIS}$ is not applied to the negative word line $W_i^-$.

In practice, a control transistor $T_3$ is additionally provided to the current switch for the current $I_{DIS}$ and the base potential C is always set higher than the potential of point E of the time constant circuit RC connected to the selected word line. Thereby, the current $I_{DIS}$ normally flows into the transistor $T_3$. The potential of point E of the selected word line $W_i^+$ side becomes high only when the potential of point C is lowered, the current $I_{DIS}$ flows into the negative word line $W_i^-$ through the transistor $T_2$.

The base potential C is generated through the route from the address change detecting circuits $Z_1...Z_n$ to the delay/shaping circuit DLY. The address change detecting circuit is provided for each address input. $Z_1$ is provided for the address input $AI_1$ and is composed of the current switch consisting of transistors $T_4$ to $T_6$. Zn is provided for the input $AI_n$. Since the reference voltage $V_{R2}$ is set between the voltage at which the waveforms cross when the signals $A_i, \overline{A}_i$ change over and the H level of signal $\overline{A}_i$, either transistors $T_4$ or $T_5$ turns ON under the normal condition where the address input does not change. Thus, the current switch gives the current $I_B$ thereto.

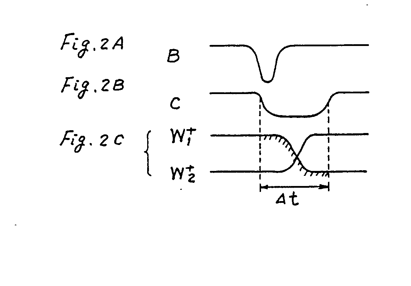

When the address input $AI_1$ changes, the conditions, $V_{R2}> A_i$ and $V_{R2}>\overline{A}_i$ are satisfied temporarily and therefore the current $I_B$ flows into the resistor $R_1$ through the transistor $T_6$. Since the collectors of transistors $T_6$ in the other address change detecting circuits are all connected to the connecting point B of the collector of transistor $T_6$ and the resistor $R_1$, if any of the address inputs $AI_1, AI_2$, changes, a current flows into the resistor $R_1$. When the current $I_B$ flows into the resistor $R_1$, the potential of point B temporarily lowers as shown in Fig. 2A. The diode D provided in parallel with the resistor $R_1$ is the clamping diode which prevents fluctuation of potential at the point B which may occur due to a difference of current flowing into the resistor $R_1$.

As will be obvious from above explanation, reduction of potential at the point B forecasts a change of voltage of the word line which may occur thereafter $W_i^+$ of Fig. 2C indicates the potential change of the word line which shifts from the selected condition to the non-selected condition, while $W_j^+$ indicates that word line which shifts from the non-selected to selected condition. As shown in the operating waveform of the same figure, drop of the potential at the point B generally does not cover the cross point of potential on the word lines $W_i^+$ and $W_j^+$. Therefore, after the potential of the point B is shifted by the transistor $T_7$, the width of the wave form of the potential is enlarged by the delay/shaping circuit DLY consisting of the adequate number of AND gates AND and the OR gates OR, then an output of such DLY is used as the base potential for controlling the transistor $T_3$ explained above. Thereby, only during the short period t where the base potential C becomes low level, namely only in the hatched period where the selected word line $W_1^+$ is shifted to the non-selected level, the discharge current $I_{DIS}$ flows into the corresponding negative word line. As a result, the discharge current $I_{DIS}$ accurately flows only when the potential of word line falls. This is the most important condition. Thereby, the voltage of the selected word line rises quickly and said discharge current $I_{DIS}$ does not flow when the selected word line voltage rises and during the normal condition. Thus, the write current no longer increases or noise margin also does not decrease.

**Claims**

1. A semiconductor memory device comprising a plurality of positive word lines ($W^+$), a plurality of negative word lines ($W^-$), a plurality of ECL memory cells ($MC_{11}$, $MC_{12}$) connected between the positive and negative word lines, plural word line level detecting transistors ($T_1$) having a base connected to the positive word lines respectively, plural first discharge transistors ($T_2$) connected to the negative word lines respectively, and a discharge current ($I_{DIs}$) provided commonly to the discharge transistors ($T_2$), characterised in that said semiconductor memory device comprises a detection circuit ($Z_1,...Z_n$) which detects changes of the address signal, a second discharge transistor ($T_3$) having an emitter commonly connected to the emitters of said first discharge transistors ($T_2$) and the discharge current so as to form a current switch together with the first discharge transistors, and a waveform shaping means (DLY) connected to the detection circuit to form the output signal of the detection circuit, said second discharge transistor ($T_3$) turning OFF in accordance with an output of said waveform shaping means, said first discharge transistors ($T_2$) turning ON selectively in accordance with the detected output (B, C) of said detection circuit and a detected output (E) of said word line level detecting transistor so as to flow temporarily through said negative word line ($W_i^-$) only when said first transistor ($T_2$) turns ON due to the change of the address signal.

2. A semiconductor memory device as set forth in claim 1, wherein said detecting circuit ($Z_1,...,Z_n$) comprises a third transistor ($T_4$) which receives a first address signal ($A_1$) at the base, a forth transistor ($T_5$) which receives a second address signal $\overline{(A_1)}$ which is complementary to the first address signal ($A_1$) at the base and a fifth ($T_6$), transistor to the base of which a first reference voltage ($V_{R2}$) is applied, and the emitters of said third, fourth and fifth transistors ($T_4$, $T_5$, $T_6$) are connected in common.

3. A semiconductor memory device as set forth in claim 2, wherein said first reference voltage ($V_{R2}$) is higher than the voltage at which said first address signal and said second address signal become the same in level when the high level and low level of said both signals are mutually inverted but lower than said high level.

4. A semiconductor memory device as set forth in claim 1, wherein said waveform shaping means (DLY) comprises a means for delaying an input signal of said waveform shaping means and a means for obtaining logical OR circuit of said input signal and said delayed signal.

**Patentansprüche**

1. Halbleiterspeichervorrichtung mit einer Vielzahl von positiven Wortleitungen ($W^+$), einer Vielzahl von negativen Wortleitungen ($W^-$), einer Vielzahl von ELC - Speicherzellen ($MC_{11}$, $MC_{12}$), die zwischen den positiven und negativen Wortleitungen angeschlossen sind, vielen Wortleitungspegel - Detektortransistoren ($T_1$), die eine Basis haben, die jeweils mit den positiven Wortleitungen verbunden sind, vielen ersten Entladungstransistoren ($T_2$), die jeweils mit den negativen Wortleitungen verbunden sind, und einem Entladungsstrom ($I_{Dis}$), der den Entladungstransistoren ($T_2$) gemeinsam geliefert wird, dadurch gekennzeichnet, daß die Halbleiterspeichervorrichtung umfaßt: eine Detektorschaltung ($Z_1,...Z_n$), die Änderungen des Adressensignals detektiert, einen zweiten Entladungstransistor ($T_3$), der einen Emitter hat, der gemeinsam mit den Emittern des ersten Entladungstransistors ($T_2$) und dem Entladungsstrom verbunden ist, um so zusammen mit dem ersten Entladungstransistor einen Stromschalter zu bilden, und eine Wellenformereinrichtung (DYL), die mit der Detektorschaltung verbunden ist, um das Ausgangssignal der Detektorschaltung zu bilden, der zweite Entladungstransistor ($T_3$) in Übereinstimmung mit einem Ausgang der Wellenformereinrichtung AUS schaltet, die ersten Entladungstransistoren ($T_2$) selektiv in Übereinstimmung mit dem detektierten Ausgang (B, C) der Detektorschaltung und einem detektierten Ausgang (E) des Wortleitungspegel - Detektortransistors EIN schalten um so temporär nur dann durch die genannte negative Wortleitung ($W_i^-$) einen Strom zu fließen, wenn der erste Transistor ($T_2$) aufgrund der Änderung des Adressensignals EIN schaltet.

2. Halbleiterspeichervorrichtung nach Anspruch 1, bei der die Detektorschaltung ($Z_1,...,Z_n$) einen dritten Transistor ($T_4$) umfaßt, der ein erstes Adressensignal ($A_1$) an der Basis empfängt, einen vierten Transistor ($T_5$), der, an der Basis, ein zweites Adressensignal $\overline{(A_1)}$ empfängt, das komplementär zu dem ersten Adressensignal ($A_1$) ist, und einen fünften Transistor ($T_6$), and dessen Basis die erste Referenzspannung angelegt wird, und bei welcher die Emitter der dritten, vierten un fünften Transistoren ($T_4$, $T_5$, $T_6$) gemeinsam verbunden sind.

3. Halbleiterspeichervorrichtung nach Anspruch 2, bei der die erste Referenzspannung $(V_{R2})$ höher als die Spannung ist, bei der das erste Adressensignal und das zweite Adressensignal denselben Pegel annehmen, wenn der hohe Pegel und der niedrige Pegel beider Signale wechselseitig invertiert jedoch niedriger als der genannte hohe Pegel sind.

4. Halbleiterspeichervorrichtung nach Anspruch 1, bei der die Wellenformereinrichtung (DYL) eine Einrichtung zur Verzögerung eines Eingangssignals der Wellenformereinrichtung und eine Einrichtung zum Erhalten einer logischen ODER-Schaltung des genannten Eingangssignals und des genannten verzögerten Signals umfaßt.

## Revendications

1. Dispositif de mémoire semiconducteur comprenant:

— plusiers lignes de mot positives $(W^+)$,
— plusieurs lignes de mot négatives $(W^-)$,
— plusieurs cellules de mémoire ECL $(MC_{11}, MC_{12})$ connectées entre les lignes de mot positives et négatives,
— plusieurs transistors $(T_1)$ de détection de niveau de ligne de mot dont les bases sont respectivement connectées aux lignes de mot positives,
— plusieurs premiers transistors de décharge $(T_2)$ respectivement connectés aux lignes de mot négatives, et
— un courant de décharge $(I_{Dis})$ fourni en commun aux transistors de décharge $(T_2)$, caractérisé en ce que ledit dispositif de mémoire semiconducteur comprend:
— un circuit de détection $(Z_1, ..., Z_n)$ qui détecte les variations de signal d'adresse,
— un deuxième transistor de décharge $(T_3)$ possédant un émetteur connecté en commun aux émetteurs desdits premiers transistors de décharge $(T_2)$ et au courant de décharge de manière à former un commutateur de courant avec les premiers transistors de décharge, et

— un moyen conformateur de formes d'onde (DLY) connecté au circuit de détection de manière à former le signal de sortie du circuit de détection,
— ledit deuxième transistor de décharge $(T_3)$ devenant non conducteur en fonction d'un signal de sortie dudit moyen conformateur de formes d'onde,
— lesdits premiers transistors de décharge $(T_2)$ devenant conducteurs sélectivement en fonction du signal de sortie détecté (B, C) dudit circuit de détection et d'un signal de sortie détecté (E) dudit transistor de détection de niveau de ligne de mot de manière à circuler temporairement dans ladite ligne de mot négative $(W_i^-)$ seulement lorsque ledit premier transistor $(T_2)$ devient conducteur par suite de la variation de signal d'adresse.

2. Dispositif de mémoire semiconducteur selon la revendication 1, où ledit circuit de détection $(Z_1, ..., Z_n)$ comprend un troisième transistor $(T_4)$ qui reçoit un premier signal d'adresse $(A_1)$ sur sa base, un quatrième transistor $(T_5)$ qui reçoit un deuxième signal d'adresse $(\overline{A_1})$, qui est complémentaire du premier signal d'adresse $(A_1)$, sur sa base, et un cinquième transistor $(T_6)$ à la base duquel une première tension de référence $(V_{R2})$ est appliquée, et les émetteurs desdits troisième, quatrième et cinquième transistors $(T_4, T_5, T_6)$ sont connectés en commun.

3. Dispositif de mémoire semiconducteur selon la revendication 2, où la première tension de référence $(V_{R2})$ est plus élevée que la tension pour laquelle ledit premier signal d'adresse et ledit deuxième signal d'adresse deviennent du même niveau lorsque le niveau haut et le niveau bas des deux dits signaux s'inversent mutuellement, mais est inférieure audit niveau haut.

4. Dispositif de mèmoire semiconducteur selon la revendication 1, où ledit moyen conformateur de formes d'onde (DLY) comprend un moyen permettant de retarder un signal d'entrée dudit moyen conformateur de formes d'onde et un moyen permettant d'obtenir l'effet d'un circuit OU logique sur ledit signal d'entrée et ledit signal retardé.

Fig. 1

0 054 853

Fig.2A   B

Fig.2B   C

Fig.2C   { $W_1^+$

         { $W_2^+$

$\Delta t$